# EUROPÄISCHE PATENTSCHRIFT

(11) **EP 3 602 638 B1**
(45) Veröffentlichungstag und Bekanntmachung des Hinweises auf die Patenterteilung: **25.10.2023**
(21) Anmeldenummer: 18715632.8
(22) Anmeldetag: 29.03.2018
(51) Int. Cl.: H01L 31/18, H01L 31/05, B21D 13/10

(54) **BEARBEITUNGSVORRICHTUNG UND VERFAHREN ZUM UMFORMEN VON VERBINDUNGSLEITERN FÜR HALBLEITERBAUELEMENTE**
PROCESSING DEVICE AND METHOD FOR FORMING CONNECTION CONDUCTORS FOR SEMICONDUCTOR COMPONENTS
DISPOSITIF D'USINAGE ET PROCÉDÉ DE FORMAGE DE CONDUCTEURS DE CONNEXION POUR COMPOSANTS À SEMI-CONDUCTEURS

(30) Priorität: 31.03.2017 DE 102017106997
(43) Veröffentlichungstag der Anmeldung: 05.02.2020
(73) Patentinhaber: Fraunhofer-Gesellschaft zur Förderung der angewandten Forschung e.V., 80686 München (DE)
(72) Erfinder: RENDLER, Li Carlos, 79102 Freiburg (DE)
(74) Vertreter: LBP Lemcke, Brommer & Partner Patentanwälte mbB
(86) Internationale Anmeldenummer: PCT/EP2018/058197
(87) Internationale Veröffentlichungsnummer: WO 2018/178292

(56) Entgegenhaltungen:
- EP-A1- 2 466 648
- EP-A1- 2 704 213
- WO-A1-2008/080160
- DE-A1- 19 915 488

## Beschreibung

Die Erfindung betrifft eine Bearbeitungsvorrichtung und ein Verfahren zum Umformen von Verbindungsleitern für Halbleiterbauelemente.

Zur elektrischen Kontaktierung von Halbleiterbauelementen werden Verbindungsleiter eingesetzt. Solche Verbindungsleiter finden insbesondere bei der Verschaltung mehrerer Halbleiterbauelemente Einsatz, beispielsweise bei der Verschaltung von Solarzellen in einem Solarzellenmodul. Hier ist es bekannt, durch Verwendung von Zellverbindern als Verbindungsleiter benachbarte Solarzellen in einer Reihenschaltung zu verschalten.

Bei einem solchen elektrischen sowie mechanischen Verschalten von Halbleiterbauelementen mittels Verbindungsleitern können beispielsweise aufgrund unterschiedlicher Ausdehnungskoeffizienten oder asymmetrischer Verschaltungen auf Vorder- und Rückseite des Halbleiterbauelementes thermomechanische Spannungen sowie eine Verformung des Halbleiterbauelementes auftreten. Diese thermomechanischen Spannungen können Auslöser für eine Degradation oder einen Ausfall der Halbleiterbauelemente sein. Auch kann eine Verformung die Weiterverarbeitung der verschalteten Halbleiterbauelemente erschweren. Zur Reduzierung solcher thermomechanischen Spannungen ist es bekannt, Verbindungsleiter mit einer periodischen, wellenartigen Struktur zu verwenden.

EP 2 466 648 A1 beschreibt eine Vorrichtung zur Herstellung solcher wellenartig gebogenen Verbindungsleiter, bei welcher der geradlinige Verbindungsleiter zwischen zwei ineinandergreifenden Zahnrädern geführt wird und hierdurch eine periodische, wellenartige Struktur erhält, welche durch die Zahnräder vorgegeben ist. DE 19915488 A1 beschreibt eine Vorrichtung zum Biegen von Metallbändern in Trapezform, die verstellbare Klemmeinrichtungen und Biegeeinrichtungen aufweist.

Der vorliegenden Erfindung liegt die Aufgabe zugrunde, die vorbekannte Bearbeitungsvorrichtung zum Umformen von Verbindungsleitern für Halbleiterbauelemente zu verbessern und den Einsatzbereich zu erweitern.

Gelöst ist diese Aufgabe durch eine Bearbeitungsvorrichtung zum Umformen von Verbindungsleitern für Halbleiterbauelemente gemäß Anspruch 1 sowie ein Verfahren zum Umformen von Verbindungsleitern für Halbleiterbauelemente gemäß Anspruch 11. Vorteilhafte Ausführungen der Bearbeitungsvorrichtung finden sich in den Ansprüchen 2 bis 10. Vorteilhafte Ausführungen des Verfahrens finden sich in den Ansprüchen 12 bis 15.

Die erfindungsgemäße Bearbeitungsvorrichtung ist bevorzugt zur Durchführung des erfindungsgemäßen Verfahrens, insbesondere einer bevorzugten Ausführungsform hiervon, ausgebildet. Das erfindungsgemäße Verfahren ist bevorzugt zur Durchführung mittels der erfindungsgemäßen Bearbeitungsvorrichtung, insbesondere einer bevorzugten Ausführungsform hiervon, ausgebildet.

Die erfindungsgemäße Bearbeitungsvorrichtung zum Umformen von Verbindungsleitern für Halbleiterbauelemente weist eine Formeinheit zum Umformen zumindest eines Verbindungsleiters auf.

Wesentlich ist, dass die Bearbeitungsvorrichtung eine Vorschubeinheit aufweist, welche ausgebildet ist, Verbindungsleiter und Formeinheit in einer Vorschubrichtung relativ zueinander zu bewegen und dass die Formeinheit zumindest ein Anschlagelement, zumindest ein relativ zu dem Anschlagelement verschiebbares Formelement und eine Formelement-Verschiebeeinheit zum Verschieben des Formelementes relativ zu dem Anschlagelement aufweist. Formelement, Anschlagelement und Formelement-Verschiebeeinheit sind derart zusammenwirkend ausgebildet, dass der Verbindungsleiter durch Verschieben des Formelementes mittels der Formelementverschiebeeinheit zwischen Anschlagelement und Formelement biegbar ist.

Im Unterschied zum Stand der Technik, bei welchem ineinandergreifende, sich gegensinnig drehende Zahnräder als Formeinheit verwendet werden, weist die erfindungsgemäße Bearbeitungsvorrichtung somit ein Formelement auf, welches mittels einer Formelement-Verschiebeeinheit relativ zu einem Anschlagelement verschoben wird. Der Verbindungsleiter kann somit, indem er einerseits an dem Anschlagelement und andererseits an dem Formelement anliegt, durch die Verschiebebewegung gebogen werden.

Die Erfindung ist auf der Erkenntnis des Erfinders begründet, dass das Herstellen einer periodischen, wellenartigen Struktur durch Biegen des Verbindungsleiters zwischen zwei ineinandergreifenden Zahnrädern typischerweise zu einer Beschädigung des Verbindungsleiters führt: Das Umformen des Verbindungsleiters zwischen den beiden Zahnrädern führt zu einer Streckung in Teilbereichen des Verbindungsleiters, so dass in periodischen Abständen eine Verjüngung des Querschnitts des Verbindungsleiters die Folge ist. Hierdurch ergibt sich ein uneinheitlicher Leitungswiderstand und insbesondere eine Erhöhung des Leitungswiderstandes aufgrund der Bereiche mit verjüngtem Querschnitt. Weiterhin haben Versuche gezeigt, dass häufig eine Schädigung des Verbindungsleiters durch Deformation des Verbindungsleiters, beispielsweise Ausbilden von Kanten und/oder Eindruckstellen in dem Verbindungsleiter bei der Bearbeitung mittels Zahnrädern erfolgt, wie Versuche des Erfinders zeigen.

Weiterhin ist die Periodenlänge sowie Amplitude einer mittels zweier gegensinnig laufender Zahnräder erstellten periodischen Struktur eines Verbindungsleiters durch die Geometrie der Zahnräder festgelegt.

Die erfindungsgemäße Bearbeitungsvorrichtung vermeidet diese Nachteile, indem das Formelement relativ zu dem Anschlagelement verschoben wird und hierdurch der zwischen Formelement und Anschlagelement angeordnete Verbindungsleiter gebogen wird. Diese Bearbeitungsart führt zu keinen oder zumindest erheblich geringeren Schädigungen des Verbindungsleiters und ebenso zu keiner oder lediglich einer vernachlässigbaren Querschnittsveränderung.

Darüber hinaus kann durch Wahl der Vorschubgeschwindigkeit bzw. der Vorschubstrecke im Zusammenspiel mit dem Verschiebeweg zwischen Formelement und Anschlagelement eine Variation von Amplitude und Periodenlänge der Struktur des bearbeiteten Verbindungsleiters erzielt werden, ins besondere können wahlweise Amplitude und/oder Periodenlänge vorgegeben und auch variiert werden.

Hierdurch werden somit Degradationen bis hin zu Ausfällen der verbundenen Halbleiterbauelemente aufgrund geringerer Schädigung und/oder Verjüngung des Verbindungsleiters reduziert. Weiterhin ist die Bearbeitungsvorrichtung flexibel für unterschiedliche Anwendungen und unterschiedliche Halbleiterbauelemente einsetzbar, welche unterschiedliche Periodenlängen und/oder Amplituden einer periodischen Struktur des Verbindungsleiters erfordern. Ebenso können Verbindungsleiter mit einer sich ändernden Amplitude und/oder mit einer sich ändernden Periodenlänge erzeugt werden.

Das erfindungsgemäße Verfahren zum Umformen von Verbindungsleitern für Halbleiterbauelemente, insbesondere zum Ausbilden einer periodischen Struktur weist folgende Verfahrensschritte auf:
In einem Verfahrensschritt A erfolgt ein Anordnen eines Verbindungsleiters zwischen einem Anschlagelement und einem Formelement einer Formeinheit. In einem Verfahrensschritt B erfolgt ein Biegen des Verbindungsleiters durch Verschieben des Formelementes relativ zu dem Anschlagelement und in einem Verfahrensschritt C erfolgt ein Bewegen des Verbindungsleiters relativ zu der Formeinheit.

Hierdurch werden die zuvor genannten Vorteile erzielt.

Vorteilhafterweise erfolgt zwischen Verfahrensschritt B und Verfahrensschritt C ein Verschieben des Formelementes relativ zu dem Anschlagelement in entgegengesetzter Richtung verglichen mit Verfahrensschritt B. Durch dieses Zurückfahren des Formelementes vor Bewegen des Verbindungsleiters relativ zu der Formeinheit in Verfahrensschritt C wird die Relativbewegung zwischen Verbindungsleiter und Formeinheit vereinfacht, da kein oder nur eine geringere Bremswirkung durch eine Reibung zwischen Verbindungsleiter, Formelement und Anschlagelement erfolgt. Insbesondere ist es vorteilhaft, zwischen Verfahrensschritt B und Verfahrensschritt C das Formelement derart zu verschieben, dass während des Bewegens des Verbindungsleiters relativ zu der Formeinheit in Verfahrensschritt C kein Kontakt zwischen Verbindungsleiter und Formelement erfolgt. Vorteilhafterweise wird daher vor einem Vorschub des Verbindungsleiters das Formelement in eine Vorschubposition verfahren, wobei sich das Formelement in Vorschubrichtung hinter dem Anschlagelement, bevorzugt mittig zu dem Anschlagelement befindet. Hierdurch wird ein Kontakt zwischen Verbindungsleiter und Formelement während des Vorschubs vermieden oder zumindest erheblich verringert.

Vorteilhafterweise weist die Formeinheit zusätzlich zu dem Anschlagelement als erstem Anschlagelement zumindest ein zweites Anschlagelement und zusätzlich zu dem Formelement als erstem Formelement zumindest ein zweites Formelement auf, welche derart angeordnet sind, dass der Verbindungsleiter zwischen erstem und zweitem Anschlagelement und zwischen dem ersten und dem zweiten Formelement anordenbar ist.

Eine Bearbeitung erfolgt bevorzugt derart, dass durch Verschieben eines Formelementes der Verbindungsleiter in Kontakt mit diesem Formelement und einem Anschlagelement gelangt und hierdurch ein Verbiegen in einer ersten Verbiegungsrichtung erfolgt. Anschließend erfolgt ein Verschieben des anderen Formelementes, so dass der Verbindungsleiter in Kontakt mit dem anderen Formelement und dem anderen Anschlagelement gelangt, um ein Verbiegen in einer entgegengesetzten Richtung zu bewirken.

Vorteilhafterweise sind erstes Formelement und erstes Anschlagelement auf einer Seite und zweites Formelement und zweites Anschlagelement auf der gegenüberliegenden Seite des Verbindungsleiters angeordnet. In dieser Konfiguration erfolgt somit ein Verbiegen in einer ersten Richtung mittels erstem Formelement und zweitem Anschlagelement und entsprechend ein Verbiegen in Gegenrichtung mittels zweitem Formelement und erstem Anschlagelement. Durch ein zyklisches Wiederholen dieser Verschiebungen mit zwischengeschaltetem Vorschub des Verbindungsleiters kann somit in einfacher Weise eine periodische Struktur des Verbindungsleiters erzeugt werden.

Vorteilhafterweise ist die Formelement-Verschiebeeinheit mit dem ersten und dem zweiten Formelement verbunden, so dass das erste und das zweite Formelement relativ zu erstem und zweitem Anschlagelement mittels der Formelement-Verschiebeeinheit verschiebbar sind.

Eine vorteilhafte, konstruktiv einfache Ausgestaltung ergibt sich, indem erstes und zweites Formelement auf einem gemeinsamen Formelementträger angeordnet sind. Hierdurch kann in einfacher Weise mittels der Formelement-Verschiebeeinheit ein gleichzeitiges Verschieben von erstem und zweitem Formelement erzielt werden.

Eine Bearbeitung des Verbindungsleiters erfolgt hierbei bevorzugt derart, dass der Formelementträger in einer ersten Richtung verschoben wird, um eine Verbiegung in einer ersten Verbiegungsrichtung zu erzielen, anschließend der Formelementträger in Gegenrichtung verschoben wird, so dass kein Kontakt zwischen den Formelementen und dem Verbindungsleiter besteht. Anschließend erfolgt ein Vorschub des Verbindungsleiters, woran sich ein weiteres Verschieben des Formelementträgers in Gegenrichtung anschließt, um ein Verbiegen in Gegenrichtung zu erzielen. Anschließend erfolgt wiederum ein Verschieben des Formelementträgers in der ursprünglichen Richtung, so dass kein Kontakt zwischen den Formelementen und dem Verbindungsleiter besteht und schließlich erneut ein Vorschub des Verbindungsleiters. Durch eine zyklische Abfolge dieser Verfahrensschritte kann in einfacher Weise eine periodische Struktur erstellt werden.

Die Vorschubeinheit ist der Formeinheit in Vorschubrichtung des Verbindungsleiters bevorzugt vorgelagert oder nachgelagert. Insbesondere ist es vorteilhaft, dass die Vorschubeinheit der Formeinheit in Vorschubrichtung des Verbindungsleiters vorgelagert ist. Hierdurch ergibt sich der Vorteil, dass die Vorschubeinheit an dem noch nicht bearbeiteten Verbindungsleiter, welcher typischerweise geradlinig ist, angreift. Weiterhin entsteht keine Beeinträchtigung der bearbeiteten Struktur des Verbindungsleiters, welche durch eine nachgelagerte Vorschubeinheit erfolgen könnte.

Vorteilhafterweise ist das Formelement mittels der Formelement-Verschiebeeinheit in einer Verschieberichtung verschiebbar, welche mit der Vorschubrichtung einen Winkel im Bereich 45 °C bis 90 °C, bevorzugt 70 °C bis 90 °C, insbesondere 80 °C bis 90 °C, bevorzugt 90 °C einschließt. Hierdurch ergeben sich verbesserte Bedingungen für das Verbiegen des Verbindungsleiters. Insbesondere ist es vorteilhaft, die Formelemente senkrecht zur Vorschubrichtung des Verbindungsleiters zu verschieben. Hierdurch ist darüber hinaus ein kompakter Aufbau der Bearbeitungsvorrichtung möglich.

Ein weiterer Vorteil der erfindungsgemäßen Bearbeitungsvorrichtung besteht in einer einfachen Parallelisierbarkeit:
In einer bevorzugten Ausführungsform ist die Bearbeitungsvorrichtung zur Bearbeitung einer Mehrzahl parallel geführter Verbindungsleiter ausgebildet. Die Formeinheit weist daher bevorzugt eine Mehrzahl von Anschlagelementen und eine Mehrzahl von Formelementen auf.

Insbesondere ist es vorteilhaft, dass die Bearbeitungsvorrichtung eine Mehrzahl von Anschlagelementen aufweist, welche bevorzugt in einer Reihe angeordnet sind, wobei zwischen zwei benachbarten Anschlagelementen jeweils ein Verbindungsleiter anordenbar ist. Weiterhin weist die Bearbeitungsvorrichtung in dieser bevorzugten Ausführungsform eine Mehrzahl von Formelementen auf, deren Anzahl bevorzugt der Anzahl der Anschlagelemente entspricht und welche bevorzugt in einer Reihe, insbesondere bevorzugt parallel zu den Anschlagelementen angeordnet sind, wobei zwischen zwei benachbarten Formelementen jeweils ein Verbindungsleiter anordenbar ist.

Hierdurch können somit mehrere parallel angeordnete Verbindungsleiter gleichzeitig verbogen werden. Bevorzugt werden hierbei alle Formelemente in einer gemeinsamen ersten Verschieberichtung verschoben, um eine Verbiegung der Verbindungsleiter in einer ersten Biegerichtung zu erzielen. Anschließend erfolgt bevorzugt ein Verschieben aller Formelemente in einer zweiten Verschieberichtung, welche bevorzugt der ersten Verschieberichtung entgegengesetzt ist, um eine Biegung der Verbindungsleiter in einer zweiten Biegerichtung zu erzielen, wobei bevorzugt zwischen den beiden Biegevorgängen ein Vorschub aller Verbindungsleiter erfolgt.

Vorteilhafterweise wird bei der gleichzeitigen Verarbeitung von zumindest zwei parallel angeordneten Verbindungsleitern ein Formelement, welches zwischen den Verbindungsleitern angeordnet ist, zur Bearbeitung dieser beiden Verbindungsleiter verwendet: Durch Verschieben des Formelementes in Richtung des ersten Verbindungsleiters erfolgt ein Umformen dieses Verbindungsleiters, wohingegen durch Verschieben des Formelementes in Richtung des anderen Verbindungsleiters, bevorzugt durch Verschieben in entgegengesetzte Richtung, ein Umformen des anderen Verbindungsleiters erfolgt. Bei einer bevorzugten Ausführungsform der erfindungsgemäßen Bearbeitungsvorrichtung für die parallele Umformung von n Verbindungsleitern sind somit bevorzugt n+1 Formelemente vorgesehen.

Eine konstruktiv robuste und platzsparende Ausgestaltung ergibt sich in einer bevorzugten Ausführungsform, indem die Mehrzahl von Formelementen auf einem gemeinsamen Formelementträger angeordnet ist, welcher mittels der Formelement-Verschiebeeinheit relativ zu den Anschlagelementen verschiebbar ist.

Weiterhin ist bevorzugt die Vorschubeinheit dazu ausgebildet, gleichzeitig alle Verbindungsleiter relativ zu der Formeinheit in einer Vorschubrichtung zu bewegen.

Die Bearbeitungsvorrichtung weist vorteilhafterweise eine Steuereinheit auf, welche mit der Formelement-Verschiebeeinheit und der Vorschubeinheit verbunden und derart ausgebildet ist, dass mittels der Steuereinheit eine Amplitude und eine Periodenlänge für eine mittels der Bearbeitungsvorrichtung erzeugte periodische Struktur des Verbindungsleiters wahlweise vorgebbar sind.

Hierdurch kann in einfacher Weise die erzeugte Struktur an die gewünschten geometrischen Anforderungen angepasst werden.

Vorteilhafterweise weist die Bearbeitungsvorrichtung eine Positions-Detektionseinheit zur Detektion von Kontaktierungspunkten eines Halbleiterbauelementes auf. Mittels solch einer Positions-Detektionseinheit können somit die Positionen relevanter Elemente auf dem Halbleiterbauelement individuell ermittelt werden. Dies ermöglicht eine individuelle Anpassung der Bearbeitung an das Halbleiterbauelement.

Insbesondere ist es vorteilhaft, dass die Bearbeitungsvorrichtung eine Steuereinheit wie zuvor beschrieben aufweist und die Positions-Detektionseinheit zusammenwirkend mit der Steuereinheit ausgebildet ist, so dass die mittels Umformung erzeugte Form des Verbindungsleiters abhängig von Detektionsdaten der Positions-Detektionseinheit vorgegeben wird, bevorzugt, dass eine Amplitude und/oder eine Periodenlänge und/oder ein Versatz für die Ausbildung einer periodischen Struktur vorgegeben wird. Hierdurch können insbesondere Fehlkontaktierungen aufgrund von variierenden Positionen von Kontaktierungspunkten auf den Halbleiterbauelementen kompensiert werden: So kann in einer bevorzugten Ausführungsform des erfindungsgemäßen Verfahrens mittels der Positions-Detektionseinheit eine Detektion von Kontaktierungspunkten des Halbleiterbauelementes erfolgen und die Position dieser Kontaktierungspunkte, insbesondere deren Abstand, mit vorgegebenen Daten, insbesondere einer vorgegebenen Periodenlänge und/oder Amplitude verglichen werden. Ebenso kann der Abstand mit einem vorgegebenen Normabstand verglichen werden.

Überschreitet die Abweichung eine vorgegebene Toleranzschwelle, so kann eine Anpassung von Periodenlänge und/oder Amplitude erfolgen. Hierzu wird bevorzugt eine Funktion vorgegeben, welche die Periodenlänge und/oder die Amplitude in Abhängigkeit des Abstandes der Kontaktierungspunkte beschreibt. Mit solch einer Funktion kann dann abhängig von dem mittels der Positions-Detektionseinheit bestimmten Abstand der Kontaktierungspunkte eine individuelle Periodenlänge und/oder Amplitude für das jeweilige Halbleiterbauelement bestimmt werden.

Bei der Verbindung von Halbleiterbauelementen mittels Verbindungsleitern treten neben den zuvor genannten Effekten, die zu einer Abstandsänderung von Kontaktierungspunkten in horizontaler Richtung, welche der Erstreckungsrichtung des Verbindungsleiters entspricht, auch Effekte auf, welche zu einem vertikalen Versatz führen, d. h. in etwa senkrecht zu einer Erstreckungsrichtung des Verbindungsleiters:
So können beispielsweise nebeneinanderliegende Halbleiterbauelemente nicht exakt ausgerichtet sein, so dass die Halbleiterbauelemente nicht exakt in einer Reihe liegen, sondern ein Höhenversatz auftritt, welcher somit auch zu einem vertikalen Versatz der zu kontaktierenden Kontaktierungspunkten führt. Ebenso können im Herstellungsverfahren des Halbleiterbauelementes Fehler auftreten, beispielsweise eine Dejustierung bei Ausbilden der Kontakte, insbesondere bei Ausbilden der Kontakte mittels Siebdruck, so dass das Halbleiterbauelement selbst einen gegenüber der Norm auftretenden Höhenversatz der Kontaktierungspunkte zum elektrischen Verbinden aufweist. In diesen Fällen ist es somit in einer bevorzugten Ausgestaltung vorteilhaft, mittels der Detektionseinheit einen Höhenversatz zu analysieren und bei Vorliegen eines einen vorgegebenen Schwellwert überschreitenden Höhenversatzes eine Kompensation bei der Bearbeitung der Verbindungsleiter derart vorzunehmen, dass der Höhenversatz bei Umformen des Verbindungsleiters nachgebildet wird. Insbesondere ist es hierbei vorteilhaft, in dem Bereich des Verbindungsleiters, welcher bei Verbinden zweier benachbarter Halbleiterbauelemente zwischen den Halbleiterbauelementen liegt, den detektierten Höhenversatz zu kompensieren.

Wie zuvor ausgeführt ist es somit vorteilhaft, die mittels der Bearbeitungsvorrichtung erzeugte Form des Verbindungsleiters abhängig von Detektionsdaten der Positions- Detektionseinheit vorzugeben, insbesondere Amplitude, Periodenlänge oder einen vertikalen Versatz der periodischen Struktur abhängig von Messdaten der Positions-Detektionseinheit in zumindest einem Teilbereich des Verbindungsleiters vorzugeben, bevorzugt zur Kompensation von detektierten Abweichungen hinsichtlich der räumlichen Lage von Kontaktierungspunkten der Halbleiterbaueelemente.

Die Erfindung betrifft weiterhin eine Halbleiterbauelementkontaktierungseinheit zur elektrischen Kontaktierung zumindest eines Halbleiterbauelementes mit einer erfindungsgemäßen Bearbeitungsvorrichtung, insbesondere einer bevorzugten Ausführungsform hiervon und mit einer Kontaktierungseinheit zum elektrischen Verbinden eines oder mehrerer Verbindungsleiter mit dem zumindest einen Halbleiterbauelement, wobei die Kontaktierungseinheit der Bearbeitungsvorrichtung nachgelagert angeordnet ist, so dass eine oder mehrere mittels der Bearbeitungsvorrichtung bearbeitete Verbindungsleiter mit dem Halbleiterbauelement mittels der Kontaktierungseinheit elektrisch leitend verbindbar sind.

Die Kontaktierungseinheit ist bevorzugt zum Herstellen eines elektrischen Kontaktes mittels Löten ausgebildet. Hierbei kann auf an sich bekannte Kontaktierungseinheiten zurückgegriffen werden, welche eine Heizplatte und/oder Heizlampe zum Erwärmen des Halbleiterbauelementes und Aufschmelzen des Lotes aufweisen.

In einer weiteren vorteilhaften Ausführungsform ist die Kontaktierungseinheit zum Herstellen eines elektrischen Kontaktes mittels Kleben (mit elektrisch leitfähigem Klebstoff) ausgebildet. Hierdurch kann die Verbindung mit geringerem Wärmeeintrag verglichen mit einem Lötvorgang hergestellt werden. Auch können Klebverbindungen mechanische Spannungen verringern.

Weiterhin weist die Halbleiterkontaktierungseinheit bevorzugt Zuführeinheiten zum Zuführen von Lotes für einen Lötvorgang oder von Klebstoff für einen Klebevorgang zu den Kontaktierungspunkten und Führungseinheiten für den bearbeiteten Verbindungsleiter zu dem Halbleiterbauelement auf. Ebenso ist die Verwendung von beloteten Verbindungsleitern möglich. Hierdurch ergibt sich der Vorteil, dass kein Lot zugeführt werden muss.

Bei dem erfindungsgemäßen Verfahren erfolgt bevorzugt während des Biegens des Verbindungsleiters kein Bewegen des Verbindungsleiters relativ zur Formeinheit mittels der Vorschubeinheit. Hierdurch wird eine Beschädigung des Verbindungsleiters vermieden und darüber hinaus kann sich die Präzision des Biegevorgangs bei gleichzeitigem Biegen und Verschieben verringern.

Vorteilhafterweise erfolgt bei dem erfindungsgemäßen Verfahren in Verfahrensschritt B ein Biegen des Verbindungsleiters durch Verschieben des Formelementes relativ zu dem Anschlagelement in einer ersten Verschieberichtung und in einem Verfahrensschritt D nach Verfahrensschritt C erfolgt ein Biegen des Verbindungsleiters durch Verschieben eines weiteren Formelementes in eine zweite Verschieberichtung relativ zu einem zweiten Anschlagelement, wobei erste und zweite Verschieberichtung unterschiedlich, bevorzugt entgegengesetzt sind. Wie bereits vorangehend beschrieben, kann hierdurch in einfacher Weise eine periodische Struktur erzeugt werden.

Vorteilhafterweise wird eine Abfolge B-C-D-C der Verfahrensschritte mehrfach wiederholt, um eine periodische Struktur zu erzeugen. Vorteilhafterweise wird hierbei in den Verfahrensschritten B und D der Verbindungsleiter nicht mittels der Vorschubeinheit bewegt, um eine Beschädigung zu vermeiden und die Präzision beim Biegen zu erhöhen.

Vorteilhafterweise wird bei dem erfindungsgemäßen Verfahren die Lage von Kennpunkten, insbesondere von Kontaktierungspunkten auf dem Halbleiterbauelement detektiert und abhängig von diesen Messdaten wird eine Kenngröße für die Verarbeitung des Verbindungsleiters vorgegeben, insbesondere bevorzugt eine Amplitude und/oder eine Periodenlänge für die Ausbildung einer periodischen Struktur. Hierdurch kann die Bearbeitung somit Ungenauigkeiten bei der Herstellung des Halbleiterbauelementes angepasst werden.

Wie zuvor beschrieben, erfolgt ein Verbiegen durch Verschieben des Formelementes. Beim Biegevorgang befindet sich der Verbindungsleiter somit bevorzugt zwischen Anschlagelement und Formelement, das heißt Anschlagelement und Formelement befinden sich auf gegenüberliegenden Seiten des Verbindungsleiters.

Vorteilhafterweise ist die Vorschubrichtung, in welcher der Verbindungsleiter mittels der Vorschubeinheit bewegt wird, parallel zur Längserstreckung des noch nicht bearbeiteten Verbindungsleiters. Hierdurch wird eine Beschädigung des Verbindungsleiters durch eine etwaige Reibung innerhalb der Vorschubeinheit vermieden.

Es liegt im Rahmen der Erfindung, dass zur Bearbeitung des Verbindungsleiters der Verbindungsleiter ortsfest angeordnet ist und die Formeinheit mittels der Vorschubeinheit relativ zu dem ortsfesten Verbindungsleiter bewegt wird. In dieser vorteilhaften Ausgestaltung kann somit insbesondere eine sequentielle Bearbeitung erfolgen, indem abwechselnd einer oder mehrere parallel liegende Verbindungsleiter bearbeitet werden, wobei die Verbindungsleiter ortsfest sind und anschließend die bearbeiteten Verbindungsleiter einem oder mehreren Halbleiterbauelementen zur Verbindung, insbesondere elektrisch leitenden Verbindungen zugeführt werden.

Vorteilhafterweise wird hierbei der Verbindungsleiter zunächst in einem ersten Bereich umgeformt, zur Verbindung mit einem ersten Halbleiterbauelement. Anschließend wird das Halbleiterbauelement an diesem umgeformten Bereich angeordnet und mit dem Verbindungsleiter mechanisch und elektrisch leitend verbunden. Anschließend wird der weitere, noch nicht umgeformte Verbindungsleiter bearbeitet und danach mit einem weiteren Halbleiterbauelement mechanisch und elektrisch leitend verbunden. Hierdurch ergibt sich der Vorteil, dass der Verbindungsvorgang sequentiell erfolgt und nicht für alle mit dem Verbindungsleiter zu verbindenden Halbleiterbauelemente gleichzeitig erfolgen muss.

In einer vorteilhaften alternativen Ausführungsform werden zunächst die Verbindungsleiter vollständig umgeformt und anschließend die Halbleiterbauelemente an den Verbindungsleitern positioniert und mechanisch und elektrisch leitend verbunden.

In einer vorteilhaften Ausführungsform der Bearbeitungsvorrichtung ist die Formeinheit ortsfest und der Verbindungsleiter wird mittels der Vorschubeinheit bewegt. Hierdurch ergibt sich der Vorteil, dass auf aufwändige Komponenten zum Bewegen der Formeinheit verzichtet werden kann.

Die erfindungsgemäße Bearbeitungsvorrichtung und des erfindungsgemäße Verfahren sind grundsätzlich zum Erstellen von Strukturen, insbesondere periodischen Strukturen des Verbindungsleiters in beliebiger Länge geeignet. Vorteilhafterweise weist die Bearbeitungsvorrichtung zumindest ein Begrenzungselement auf, welches der Formeinheit nachgeordnet ist. Das Begrenzungselement ist bevorzugt als Wand, insbesondere bevorzugt als Steg ausgebildet und derart angeordnet, dass eine Bewegung des bearbeiteten Verbindungsleiters in Biegerichtung vermieden oder zumindest reduziert wird. Insbesondere bei der vorteilhaften Ausbildung der Bearbeitungsvorrichtung zur Bearbeitung mehrerer paralleler Verbindungsleiter sind bevorzugt mehrere, bevorzugt parallel angeordnete Begrenzungselemente der Formeinheit nachgeordnet.

Mittels eines oder mehrerer Begrenzungselemente wie zuvor beschrieben wird somit auch ein Vorschub des bearbeiteten Verbindungsleiters in Vorschubrichtung während des Vorschubs des unbearbeiteten Verbindungsleiters mittels der Vorschubeinheit gewährleistet.

Die Begrenzungselemente weisen bevorzugt einen Abstand zueinander auf, welcher zumindest der maximalen Gesamtamplitude der erzeugten Struktur des Verbindungsleiters entspricht. Wie weiter unten erläutert, kann vorteilhafterweise ein vertikaler Versatz von Kontaktierungspunkten der Halbleiterbauelemente durch die Form des Verbindungsleiters kompensiert werden. Vorteilhafterweise weisen die Begrenzungselemente daher einen Abstand auf, welcher zumindest der Summe der Gesamtamplitude und eines vorgegebenen maximalen vertikalen Versatzes, welcher gegebenenfalls durch die Form des Verbindungsleiters kompensiert werden soll, entspricht.

Vorteilhafterweise weist die Bearbeitungsvorrichtung eine Trenneinheit mit Trennwerkzeugen, insbesondere Schneidwerkzeugen auf, um den bearbeiteten Verbindungsleiter zu durchtrennen. Die Trenneinheit ist der Formeinheit und insbesondere bevorzugt dem Begrenzungselement nachgeordnet angeordnet. Bei Ausbildung der Bearbeitungsvorrichtung zur Bearbeitung mehrerer parallel liegender Verbindungsleiter weist die Trenneinheit bevorzugt Trennwerkzeuge für jeden Verbindungsleiter auf.

Die vorliegende Erfindung ist insbesondere geeignet, um periodische Strukturen, insbesondere rechteckartige, insbesondere rechteckartige mit abgeschrägten Flanken, wellenartige, sinusartige, dreieckartige oder sägezahnartige Strukturen an den Verbindungsleitern auszubilden oder zumindest näherungsweise solche Formen.

Bevorzugt ist die Form des Formelementes und/oder der horizontale Abstand (das heißt der Abstand in Erstreckungsrichtung des Verbindungsleiters) von Formelement und Anschlagselement an die zu erzeugende Form des Verbindungsleiters mittels Umformung angepasst.

Bevorzugt weist das Formelement eine runde oder zumindest abgerundete Form auf, um das Risiko von Beschädigungen des Verbindungsleiters zu verringern. Gleiches gilt für das Anschlagelement.

Vorteilhafterweise weist das Formelement in Vorschubrichtung eine Länge auf, welcher kleiner als eine halbe Periodenlänge der herzustellenden periodischen Struktur ist.

Vorteilhaft ist die Verwendung von zylindrischen Formelementen, deren Zylinderachse senkrecht zur Vorschubrichtung angeordnet sind. Insbesondere ist die Verwendung von zylindrischen Formelementen mit kreisförmiger oder elliptischer Querschnittsfläche vorteilhaft. Ebenso liegt die Verwendung von zylindrischen Formelementen mit anderen Querschnittsflächen im Rahmen der Erfindung, insbesondere rechteckige Querschnittsflächen, bevorzugt mit abgerundeten Kanten.

Weitere vorteilhafte Merkmale und bevorzugte Ausführungsformen werden nachfolgend anhand von Ausführungsbeispielen und den Figuren erläutert. Dabei zeigt:
- Figur 1: ein erstes Ausführungsbeispiel einer erfindungsgemäßen Bearbeitungsvorrichtung in Seitenansicht;
- Figur 2: das erstes Ausführungsbeispiel gemäß Figur 1 in Draufsicht von oben;
- Figur 3: ein zweites Ausführungsbeispiel einer erfindungsgemäßen Bearbeitungsvorrichtung mit verschiebbarer Formeinheit in Draufsicht von oben;
- Figur 4: ein Anwendungsbeispiel für bearbeitete Verbindungsleiter zur elektrischen Reihenschaltung von beidseitig kontaktierten Solarzellen;
- Figur 5: ein Anwendungsbeispiel für bearbeitete Verbindungsleiter zur elektrischen Reihenschaltung von Rückseitenkontaktsolarzellen;
- Figur 6: ein Anwendungsbeispiel zur Erläuterung der Anpassung der Periodenlänge an unterschiedliche Zellabstände;
- Figur 7: ein Ausführungsbeispiel zur Erläuterung der Anpassung der Periodenlänge für unterschiedliche Abstände von Kontaktierungspunkten und
- Figur 8: ein Ausführungsbeispiel zur Erläuterung der Anpassung der Form der Verbindungsleiter an einen vertikalen Versatz.

In den Figuren bezeichnen gleiche Bezugszeichen gleiche oder gleichwirkende Elemente.

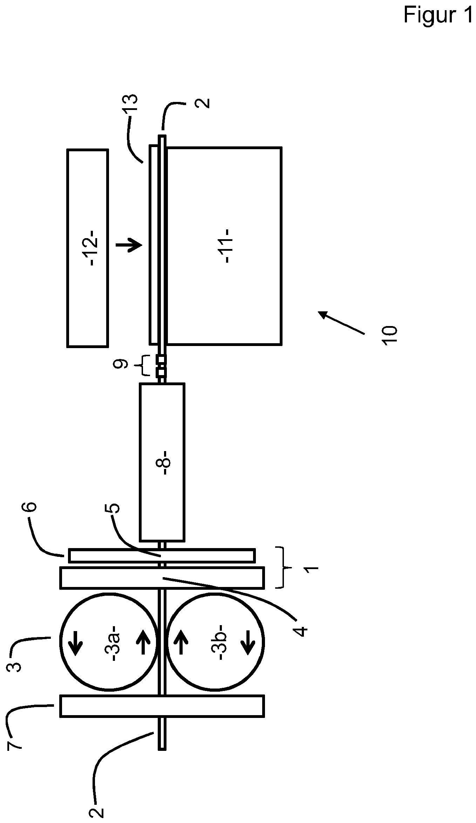

In Figur 1 ist ein erstes Ausführungsbeispiel einer erfindungsgemäßen Bearbeitungsvorrichtung in Seitenansicht dargestellt. Die Bearbeitungsvorrichtung ist zum Umformen einer Mehrzahl parallel angeordneter Verbindungsleiter für Halbleiterbauelemente ausgebildet. Vorliegend sind photovoltaische Solarzellen als Halbleiterbauelemente zum Verbinden mittels der Verbindungsleiter gezeigt. Ebenso ist die Verwendung für andere Halbleiterbauelemente, insbesondere großflächige Halbleiterbauelemente wie beispielsweise OLEDs möglich.

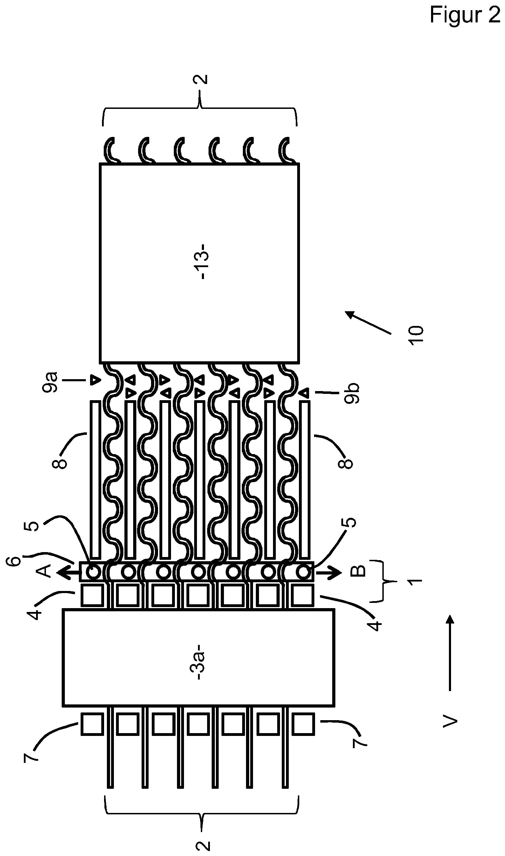

In Figur 2 ist die Bearbeitungsvorrichtung in Draufsicht von oben gezeigt. Weitere Einzelheiten werden nachfolgend mit Bezug auf die Figuren 1 und 2 erläutert:
Die Bearbeitungsvorrichtung weist eine Formeinheit 1 zum Umformen der parallel angeordneten Verbindungsleiter 2 auf.

Weiterhin weist die Bearbeitungsvorrichtung eine Vorschubeinheit 3 auf, welche vorliegend zwei motorisch angetriebene, sich gegenläufig drehende Walzen 3a und 3b umfasst. Mittels der Vorschubeinheit 3 werden die Verbindungsleiter 2 gleichzeitig und in einer Vorschubrichtung V parallel zu Längserstreckung der Verbindungsleiter der Formeinheit 1 zugeführt und somit Verbindungsleiter und Formeinheit in Vorschubrichtung relativ zueinander bewegt. Bei dem vorliegenden Ausführungsbeispiel ist somit die Formeinheit ortsfest ausgebildet und die Verbindungsleiter werden mittels der Vorschubeinheit relativ zur Formeinheit bewegt.

Die Formeinheit 1 weist eine Mehrzahl von Anschlagelementen 4 und eine Mehrzahl von Formelementen 5 auf. Die Anschlagelemente 4 und die Formelemente 5 sind jeweils in einer Reihe angeordnet, wobei sich beide Reihen parallel zueinander und senkrecht zur Vorschubrichtung V erstrecken. Aus Gründen der Übersichtlichkeit sind in Figur 2 lediglich das erste und das letzte Anschlagelement der in Reihe angeordneten Mehrzahl von Anschlagelementen mit Bezugszeichen 4 versehen. Gleiches gilt für die in Reihe angeordneten Verformungskörper 5.

Alle Formelemente 5 sind auf einem gemeinsamen Formelementträger 6 angeordnet. In Draufsicht von oben gemäß Figur 2 liegt der Formelementträger 6 unterhalb der Verbindungsleiter 2.

Mittels einer motorisch betriebenen Formelement-Verschiebeeinheit wird der Formelementträger 6 und somit auch die Formelemente 5 in einer ersten Verschieberichtung A oder einer hierzu entgegengesetzten zweiten Verschieberichtung B (siehe Figur 2) verschoben.

Mittels der Formelemente-Verschiebeeinheit sind somit die Formelemente 5 relativ zu den Anschlagelementen 4 verschiebbar, wobei die Verschiebungsrichtung (A, D) senkrecht zur Vorschubrichtung V steht, d.h einen Winkel von 90° einschließt.

Wird nun der Formelementträger 6 verschoben, gerät jeder Verbindungsleiter 2 mit einem Formelement 5 und einem Anschlagelement 4 in Kontakt und es erfolgt ein Biegen des Verbindungsleiters. Abhängig von der gewählten Verschieberichtung A oder B ändert sich auch die Biegerichtung bei dem Biegevorgang entsprechend.

Wie in Figur 2 ersichtlich, sind die Verbindungsleiter somit jeweils zwischen zwei Anschlagelementen 4 und zwei Formelementen 5 angeordnet.

Die Bearbeitungsvorrichtung ist somit zum parallelen Bearbeiten von 6 Verbindungsleitern 2 ausgebildet und weist hierzu 7 Formelemente 5 auf. Für typische Anwendungen bei der Herstellung von Solarzellenmodulen ist eine größere Anzahl paralleler Verbindungsleiter sinnvoll, insbesondere im Bereich 10 bis 50 parallele Verbindungsleiter.

Die Vorschubeinheit 3 ist der Formeinheit 1 vorgelagert. Hierdurch ist ein fehlerfreier Vorschub gewährleistet, da die Walzen 3a und 3b der Vorschubeinheit an den geradlinigen, unbearbeiteten Verbindungsleitern angreifen. Darüber hinaus wird eine Veränderung der Form der bearbeiteten Verbindungsleiter durch die Vorschubeinheit 3 auf diese Weise vermieden.

Der Vorschubeinheit 3 vorgeordnet sind zusätzliche Führungselemente 7, welche ebenfalls in einer Reihe parallel zu der Reihe der Anschlagelemente 4 angeordnet sind. Diese Führungselemente 7 bewirken eine genaue Positionierung bei der Zuführung der Verbindungsleiter zu der Vorschubeinheit.

Der Formeinheit 1 nachgeordnet ist eine Mehrzahl von Begrenzungselementen der Bearbeitungsvorrichtung. Die Begrenzungselemente 8 sind als Stege ausgebildet und parallel zueinander und parallel zur Vorschubrichtung V angeordnet, so dass jeder bearbeitete Verbindungsleiter 2 wie in Figur 2 ersichtlich beidseitig von einem Begrenzungselement umgeben ist, das heißt sowohl in Verschieberichtung A, als auch in Verschieberichtung B ist ein Begrenzungselement vorgesehen. Es sind somit für eine Anzahl n von Verbindungsleitern n+1 Begrenzungselemente 8 vorgesehen.

Die Begrenzungselemente 8 bewirken, dass sich die Position der bereits bearbeiteten Bereiche der Verbindungsleiter während eines Biegevorgangs in Biegerichtung nicht oder nur geringfügig ändert.

Die Bearbeitungsvorrichtung weist weiterhin eine Trennvorrichtung 9 mit Schneidewerkzeugen 9a und 9b auf. Mittels der Trennvorrichtung 9 können die bearbeiteten Verbindungsleiter 2 somit getrennt werden.

In den Figuren 1 und 2 ist weiterhin eine Kontaktierungseinheit 10 gezeigt, mit einer Heizplatte 11 und einer als Lötlampe 12 ausgebildeten Lötvorrichtung. Zwischen Heizplatte 11 und Lötlampe 12 wird das Halbleiterbauelement 13 angeordnet, vorliegend eine photovoltaische Solarzelle.

Wie nachfolgend näher erläutert, werden zur Reihenschaltung zweier benachbarter Solarzellen die Verbindungsleiter bei einer Solarzelle an der Rückseite und bei der benachbarten Solarzelle anschließend an der Vorderseite angeordnet und jeweils durch Zuführen von Lot und Erhitzen mittels Heizplatte 11 und Lötlampe 12 mechanisch und elektrisch leitend mit der jeweiligen Solarzelle verbunden.

Kontaktierungseinheit 10 und die zuvor beschriebene Bearbeitungsvorrichtung bilden somit eine Halbleiterkontaktierungseinheit zur Kontaktierung eines Halbleiterbauelementes aus.

Die Formelemente 5 weisen eine zylindrische Form mit rundem Querschnitt auf, wobei die Zylinderachse in Figur 2 senkrecht zur Zeichenebene steht. Die Anschlagelemente 4 weisen näherungsweise eine quaderförmige Form auf, wobei die Kanten jedoch abgerundet sind, um eine Beschädigung des Verbindungsleiters zu vermeiden.

Wie in Figur 2 ersichtlich, können mit der Bearbeitungsvorrichtung wellenartige periodische Strukturen hergestellt werden:
In einem Ausführungsbeispiel des erfindungsgemäßen Verfahrens erfolgt in einem Verfahrensschritt A ein Anordnen der Verbindungsleiter 2 zwischen den Anschlagelementen 4 und den Formelementen 5 der Formeinheit 1. In einem Verfahrensschritt B erfolgt ein Verbiegen der Verbindungsleiter 2 durch Verschieben der Formelemente 5 in Verschieberichtung A relativ zu den Anschlagelementen 4.

Anschließend erfolgt ein Zurückfahren der Formelemente 5 durch Verschieben in Verschieberichtung B, so dass in Vorschubrichtung V die Formelemente 5 mittig oder zumindest in etwa mittig hinter den Anschlagelementen 4 angeordnet sind. In dieser Vorschubposition der Formelemente 5 besteht somit kein Kontakt zwischen Formelementen 5 und Verbindungsleitern 2. In einem Verfahrensschritt C erfolgt eine Bewegung des Verbindungsleiters in Vorschubrichtung V mittels der Vorschubeinheit 3. In einem Verfahrensschritt D erfolgt ein Verschieben der Formelemente 5 in Verschieberichtung B und somit ein Verbiegen der Verbindungsleiter 2 in der entgegengesetzten Richtung. Anschließend erfolgt ein Zurückfahren der Formelemente 5 in Verschieberichtung A, um die Vorschubposition wie zuvor beschrieben und wie in Figur 2 dargestellt zu erreichen. Diese Abfolge von Verfahrensschritten wird zyklisch wiederholt, so dass sich die in Figur 2 dargestellte periodische Struktur der Verbindungsleiter 2 ergibt.

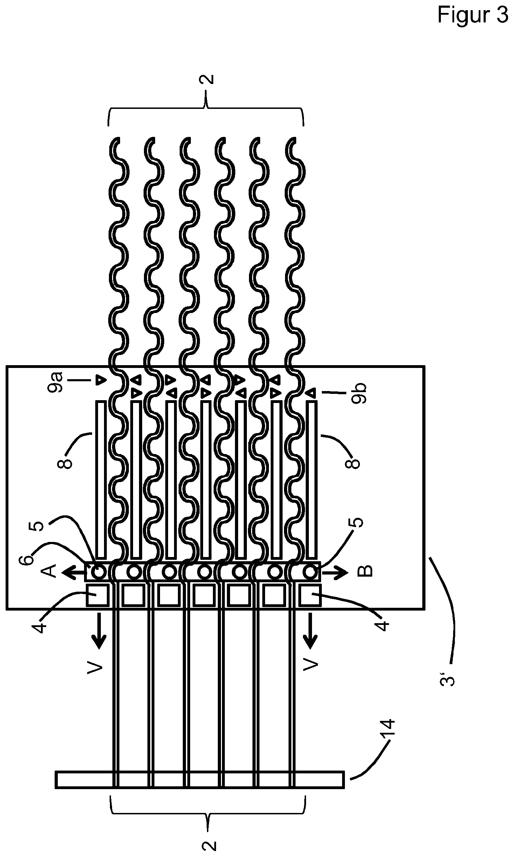

In Figur 3 ist ein zweites Ausführungsbeispiel einer erfindungsgemäßen Bearbeitungsvorrichtung gezeigt. Zur Vermeidung von Wiederholungen wird nachfolgend nur auf die wesentlichen Unterschiede zu der Bearbeitungsvorrichtung gemäß Figur 1 eingegangen: Die Bearbeitungsvorrichtung gemäß Figur 3 weist eine Vorschubeinrichtung 3' auf, welche als in Richtung V motorisch verschiebbare Halterung ausgebildet ist. Auf der Vorschubeinrichtung 3' sind die Anschlagelemente 4, die Formelement-Verschiebeeinheit, der Formelementträger 6 mit den Formelementen 5, die Begrenzungselemente 8 sowie die Schneidwerkzeuge 9a und 9b angeordnet. Die Verbindungsleiter sind an einer Halterung 14 fixiert. Bei diesem Ausführungsbeispiel sind somit die Verbindungsleiter 2 ortsfest, wohingegen die Anschlagelemente 4, die Formelement-Verschiebeeinheit sowie der Formelementträger 6 mit den Formelementen 5 in Richtung V zwischen den Biegevorgängen in Richtung V bewegt werden.

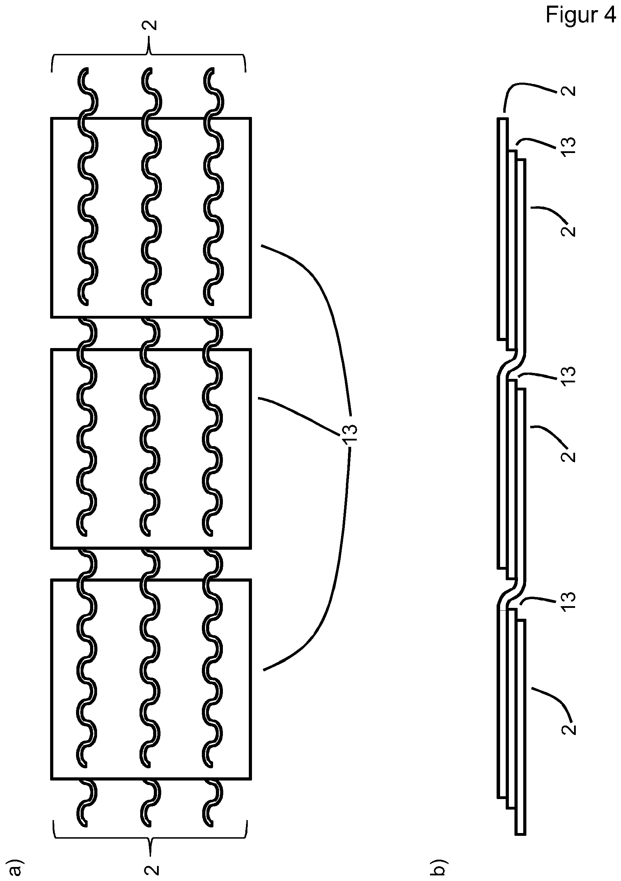

In Figur 4 ist die Verwendung der mit der in den Figuren 1 und 2 dargestellten Bearbeitungsvorrichtung hergestellten Verbindungsleiter zur Reihenschaltung der Halbleiterbauelemente 13 dargestellt. Teilbild a zeigt hierbei eine Draufsicht von oben und Teilbild b eine Seitenansicht die als beidseitig zu kontaktierende, photovoltaische Solarzellen ausgebildeten Halbleiterbauelemente 13 sind alternierend auf der in Teilbild a gezeigten Vorderseite durch die Verbindungsleiter 2 kontaktiert. Jedes Halbleiterbauelement 13 ist weiterhin mit einem benachbarten Halbleiterbauelement an dessen Rückseite kontaktiert, um eine Reihenschaltung auszubilden. In Seitenansicht gemäß Teilbild b verlaufen die Verbindungsleiter 2 somit von der Vorderseite eines Halbleiterbauelementes 13 zu der Rückseite des benachbarten Halbleiterbauelementes.

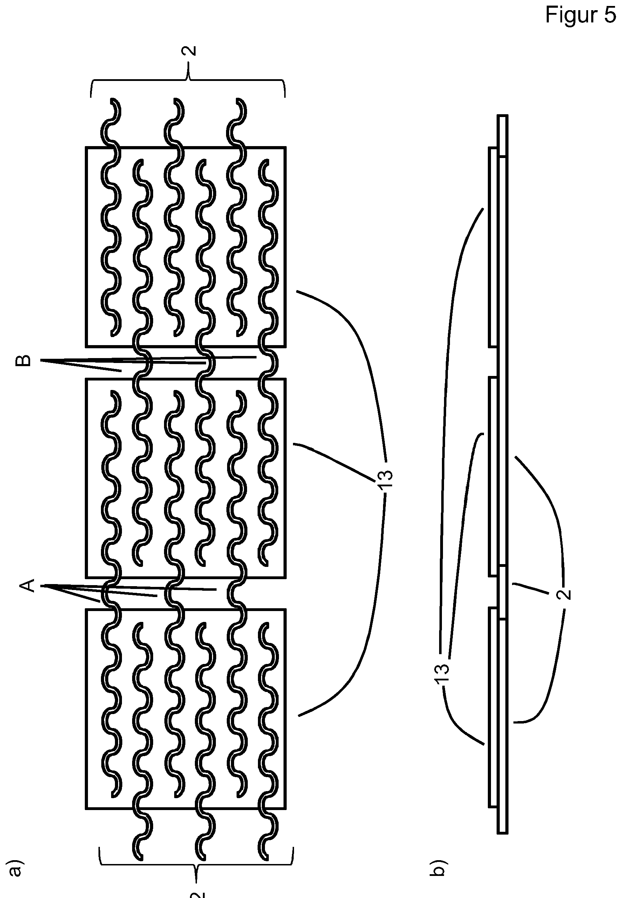

In Figur 5 ist die Verschaltung von Rückseitenkontaktsolarzellen gezeigt. In diesem Beispiel sind die Halbleiterbauelemente 13 als RückseitenkontaktSolarzellen ausgebildet. Bei solchen Solarzellen liegen die metallischen Strukturen zur Kontaktierung der Solarzelle sowohl der n-Polarität, als auch der p-Polarität auf der Rückseite. Hierdurch ist somit eine Verschaltung benachbarter Solarzellen möglich, ohne dass der Verbindungsleiter von einer Vorder- auf eine Rückseite geführt werden muss. Ebenso ist es auch möglich, Halbleiterbauelemente mit vertauschten n- und p-Polaritäten zu verwenden.

Die Rückseitenkontaktsolarzellen weisen daher auf der Rückseite in alternierenden Reihen p- und n-Kontaktstrukturen auf. Entsprechend lassen sich die Verbindungsleiter in zwei Gruppen aufteilen:
Wie in Figur 5a ersichtlich, werden zwei benachbarte Solarzellen alternierend von einer Gruppe A oder einer Gruppe B von Verbindungsleitern elektrisch leitend verbunden. In dem gezeigten Beispiel verbindet gemäß der in Figur 5a gezeigten Draufsicht von unten die Gruppe A von Verbindungsleitern n-Kontaktierungselement? der linken Solarzelle mit p-Kontaktierungselementen der mittigen Solarzelle. Die mittige Solarzelle ist somit gegenüber der linken (und auch gegenüber der rechten) Solarzelle um 180° gedreht, so dass eine umgekehrte alternierende Abfolge der n- und p-Kontaktierungselemente vorliegt. Daher erfolgt durch die Verbindungsleiter 2 der Gruppe B eine elektrisch leitende Verbindung der n-Verbindungselemente der mittigen Solarzelle zu den p-Verbindungselementen der rechten Solarzelle.

In Figur 5b ist eine Seitenansicht dieser drei mittels Verbindungsleitern 2 verbundenen Rückseitenkontaktzellen gezeigt.

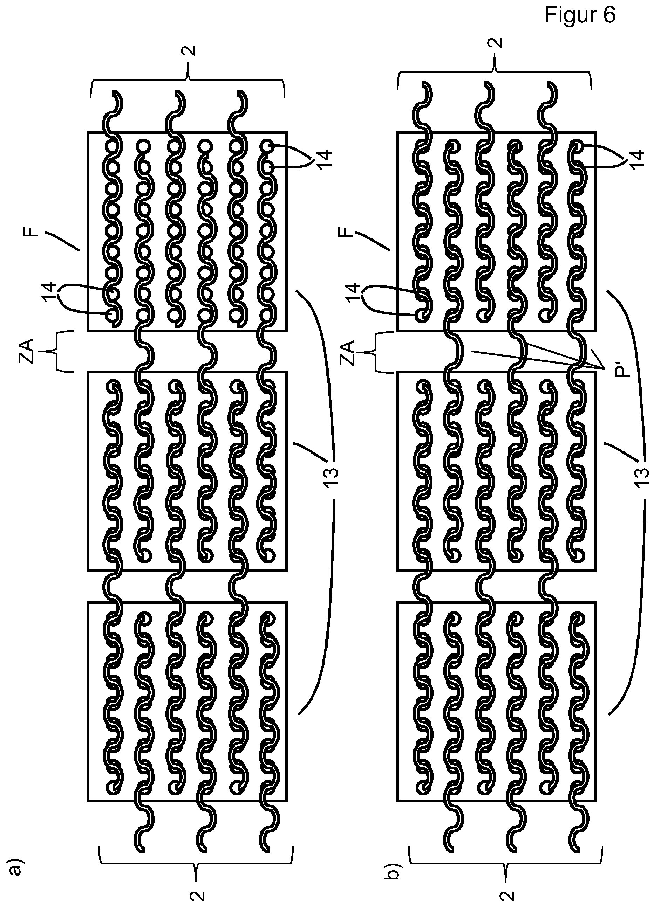

In den Figuren 6, 7 und 8 sind Kontaktierungspunkte der als Rückseitenkontaktsolarzellen ausgebildeten Halbleiterbauelementen 13 als Kreise eingezeichnet. An diesen Kontaktierungspunkten soll eine mechanische und elektrisch leitende Verbindung mit Verbindungsleitern 2 erfolgen. Zur besseren Übersichtlichkeit sind lediglich in den jeweils rechten Zellen jeweils vier Kontaktierungspunkte 14 gekennzeichnet.

In Figur 6 ist die Verwendung eines Ausführungsbeispiels der erfindungsgemäßen Vorrichtung und des erfindungsgemäßen Verfahrens zur Anpassung der Periodenlänge der Verbindungsleiter an unterschiedliche Zellabstände gezeigt: Hierfür kann eine Bearbeitungsvorrichtung gemäß Figur 1 verwendet werden, welche weiterhin eine Steuereinheit aufweist, die mit der Vorschubeinrichtung 3 und der Formelement-Verschiebeeinheit zum Verschieben des Formelementträgers 6 verbunden ist. Mittels der Steuereinheit sind Periodenlänge und Amplitude der erzeugten periodischen Struktur der Verbindungsleiter vorgebbar. Wie in Figur 6 in Teilbild a ersichtlich, kann es bei der Anordnung von Halbleiterbauelementen 13, welche vorliegend ebenfalls als Rückseitenkontaktzellen ausgebildet sind, zu unterschiedlichen Zellabständen kommen. Vorliegend ist der Zellabstand ZA zwischen der mittleren und rechten Zelle vergrößert, beispielweise gegenüber dem Zellabstand zwischen der linken und der mittleren Zelle. Wie in Figur 6 in Teilbild a ersichtlich, führt eine konstante Periodenlänge bei korrektem Zellabstand gemäß linker und mittlerer Zelle zu einer korrekten Kontaktierung aller (kreisförmig dargestellten) Kontaktierungspunkten. Bei einem vergrößerten Zellabstand ZA erfolgt jedoch eine Verschiebung der Kontaktierungspunkte relativ zu der periodischen Struktur, sofern die Abstandsänderung nicht ein ganzzahliges Vielfaches einer halben Periodenlänge der periodischen Struktur beträgt. In dem in Figur 6a dargestellten Beispiel sind die Kontaktierungspunkte des rechts dargestellten Halbleiterbauelementes 13 nicht oder nur ungenügend elektrisch kontaktiert.

In diesem Ausführungsbeispiel eines erfindungsgemäßen Verfahrens erfolgt daher eine Detektion der Ränder der Halbleiterbauelemente 13 als Kennpunkte. Alternativ können anstelle der Ränder auch andere örtliche Markierungspunkte verwendet werden, wie z.B. Kontaktierungspunkte, insbesondere Kontaktpads, Alignierungsmarker, insbesondere für vorangegangene Siebdruckprozesse oder eigens für diese Erkennung vorgesehene Marker auf dem Halbleiterbauelement.

Mittels der Steuereinheit erfolgt eine Überprüfung, ob der Abstand dieser Kennpunkte einem vorgegebenen Wert entspricht, so dass mit einer konstanten Periodenlänge eine korrekte Kontaktierung der Kontaktierungspunkte 14 erfolgt. Weicht der Abstand zwischen den Halbleiterbauelementen 13 jedoch von einer vorgegebenen Normgröße ab, so berechnet die Steuereinheit eine abweichende Periodenlänge, um die Abweichung im Abstand ZA zu kompensieren. Diese abweichende Periodenlänge wird im vorliegenden Ausführungsbeispiel bei Erzeugen der Verbindungsleiter zum Verbinden des mittigen und rechten Halbleiterbauelementes 30 für die mittlere Periode verwendet. Wie in Figur 6b ersichtlich, weisen diejenigen Verbindungsleiter 2, welche das mittlere Halbleiterbauelement 13 mit dem rechten Halbleiterbauelement 13 verbinden eine vergrößerte Periodenlänge im Zwischenraum zwischen den Halbleiterbauelementen auf. Diese vergrößerte Periodenlänge ist mit P` gekennzeichnet.

In diesem Ausführungsbeispiel eines erfindungsgemäßen Verfahrens erfolgt somit die Detektion des Abstandes zwischen der Halbleiterbauelemente 13 als Kennpunkt und bei Abweichung erfolgt eine Steuerung der Vorschubeinrichtung 3 und der Formelement-Verschiebeeinheit derart, dass in etwa mittig zwischen den äußersten Kontaktierungspunkten 14 zweier benachbarter Halbleiterbauelemente bei Erzeugen der diesen Abstand betreffenden Verbindungsleiter 2 eine geänderte Periodenlänge P' zur Kompensation des Unterschieds im Abstand der Halbleiterbauelemente erzeugt wird.

Die Detektion kann hierbei mittels einer Kamera, welche ein flächiges Bild aufnimmt, insbesondere einer CCD-Kamera und einer Bildauswerteeinheit erfolgen. Beispielsweise können diese Elemente am Ort der Lötlampe 12 in Figur 1 integriert sein. Ebenso können solche Bildaufnahmen zur Detektion der räumlichen Lage der Kennpunkte in anderen Vorrichtungen zum reihenartigen Anordnen der Halbleiterbauelemente, insbesondere eine Vorrichtung zum Herstellen eines Strings für ein Solarzellenmodul integriert sein.

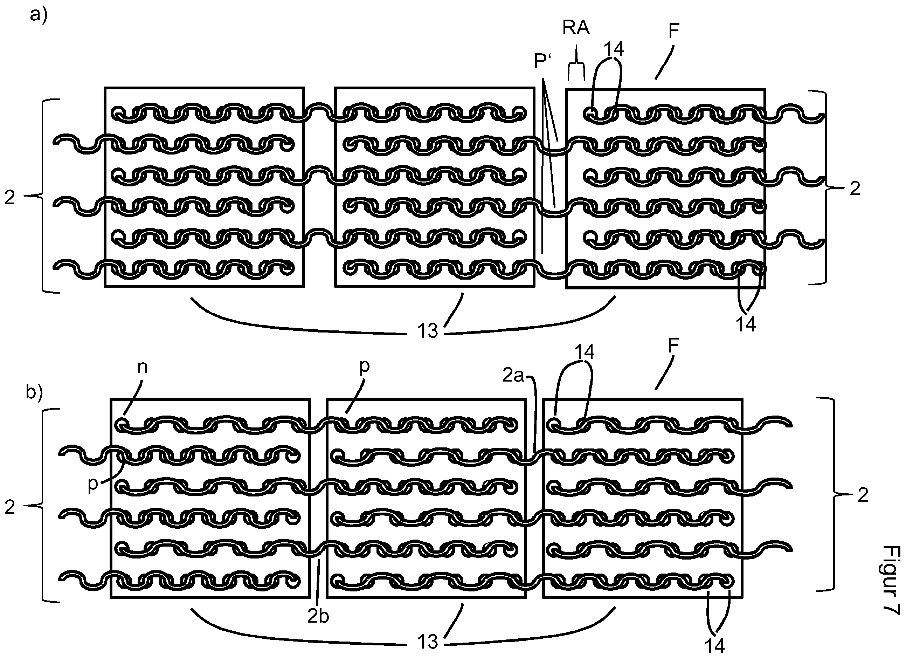

In Figur 7 sind zwei weitere Anwendungsbeispiele gezeigt, bei denen abhängig von erfassten Kennpunkten eine Anpassung der Periodenlänge der periodischen Struktur der Verbindungsleiter erfolgt:
In Figur 7a ist ein Beispiel gezeigt, bei welchem der Randabstand RA der jeweils ersten Kontaktpunkte 14 zu dem zugehörigen Rand detektiert wird. Hierdurch wird wie zuvor beschrieben mittels einer CCD-Kamera die Lage des Randes und des nächsten Kontaktierungspunktes 14 detektiert und hieraus der Abstand bestimmt. Weicht dieser Abstand von einem vorgegebenen Normabstand ab, so wird - wie bereits zu Figur 6 beschrieben - die Periodenlänge des Verbindungsleiters 2 in dem Bereich, der zwischen den zwei benachbarten als Rückseitenkontaktsolarzellen ausgebildeten Halbleiterbauelementen 13 liegt, die Periodenlänge angepasst, um die Abweichung vom Normabstand zu kompensieren. Wie in Figur 7a dargestellt, ist bei der rechts liegenden Solarzelle F bei der Protektion ein Fehler aufgetreten, welcher zu einer Verschiebung aller Kontaktpunkte 14 nach rechts führte, so dass der Abstand RA der jeweils ersten Kontaktpunkte 14 zum linken Rand der Solarzelle F größer ist, als dies der Norm (siehe die linke oder mittlere Solarzelle) entspricht. Entsprechend wurde die Periodenlänge der betreffenden Verbindungsleiter 2 im Bereich zwischen der mittleren und der rechten Solarzelle vergrößert (siehe Bezugszeichen P`), so dass eine korrekte Kontaktierung der Kontaktierungspunkte 14 mittels der Verbindungsleiter 2 erfolgt.

In Figur 7b ist ein Beispiel dargestellt, bei welchem die n-Kontaktierungsstrukturen einen anderen Abstand zueinander aufweisen gegenüber den p-Kontaktierungsstrukturen:
Wie bereits zuvor beschrieben, weisen die als Rückseitenkontaktzellen ausgebildeten Halbleiterbauelemente 13 in Reihen angeordnete Kontaktierungselemente 14 auf, welche als Kreise dargestellt sind. Wie exemplarisch gekennzeichnet, weist die obere Reihe der links angeordneten Solarzelle n-Kontaktierungsstrukturen auf. Entsprechend weist die darunterliegende Reihe p-Kontaktierungsstrukturen auf. Diese reihenartige, alternierende Anordnung ist bei allen in den Figuren dargestellten Rückseitenkontaktsolarzellen gegeben. Wie ebenfalls bereits beschrieben, ist die mittlere Solarzelle jedoch um 180 °C gedreht, so dass hier die oberste Reihe p-Kontaktierungsstrukturen aufweist und entsprechend die darunterliegende Reihe n-Kontaktierungsstrukturen und auch hier sich diese Reihen im alternierenden Wechsel fortsetzen.

In diesem Beispiel weisen die n-Kontaktierungsstrukturen einen größeren Abstand zueinander auf, verglichen mit den p-Kontaktierungsstrukturen. So verbindet beispielsweise Verbindungsleiter 2a n-Kontaktierungspunkte der mittleren Solarzelle (mit größeren Abständen) mit p-Kontaktierungspunkten der rechten Solarzelle (mit kleineren Abständen); Verbindungsleiter 2b verbindet n-Kontaktierungspunkte der linken Solarzelle (mit größeren Abständen) mit p-Kontaktierungspunkten der mittleren Solarzelle (mit kleineren Abständen).

Die Verbindungsleiter 2 sind daher derart ausgebildet, dass etwa hälftig eine größere Periodenlänge vorgegeben ist, welche dem doppelten Abstand der n-Kontaktierungsstrukturen entspricht. Entsprechend ist für den verbleibenden Verbindungsleiter eine kleinere Periodenlänge vorgegeben, welche dem Doppelten des Abstandes der p-Kontaktierungsstrukturen entspricht. In diesem Ausführungsbeispiel eines erfindungsgemäßen Verfahrens wird somit mittels der Steuereinheit für einen Verbindungsleiter eine Abfolge von Periodenlängen - vorliegend zwei - vorgegeben sowie eine Gesamtlänge oder Anzahl von Perioden, nach der ein Wechsel zu der nächsten vorgegebenen Periode erfolgen soll.

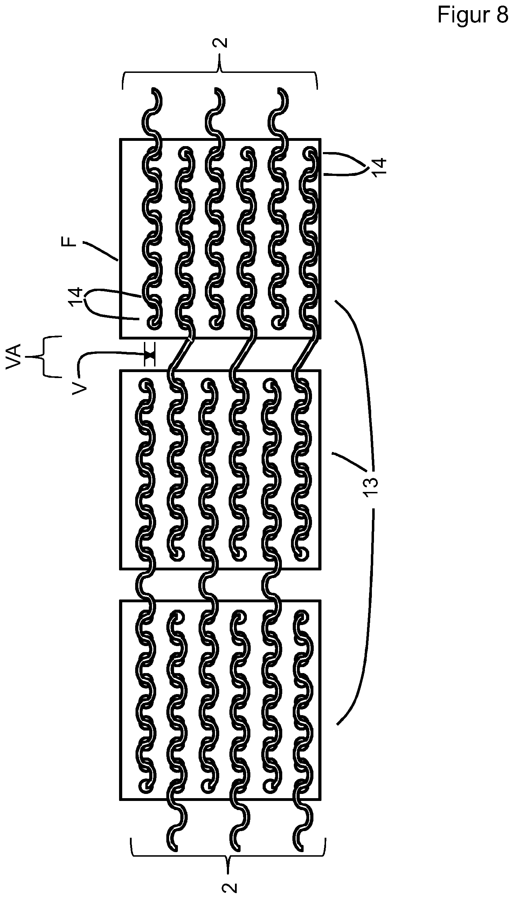

In Figur 8 ist die Verwendung eines Ausführungsbeispiels der erfindungsgemäßen Vorrichtung und des erfindungsgemäßen Verfahrens zur Anpassung der Form der Verbindungsleiter an einen vertikalen Versatz der Kontaktierungselemente 14 der Halbleiterbauelemente 13 gezeigt:
Auch hierfür kann eine Bearbeitungsvorrichtung gemäß Figur 1 verwendet werden, wobei der Abstand der Begrenzungselemente 8 zueinander in diesem Fall der Summe der maximal gewünschten Gesamtamplitude zuzüglich eines vorgegebenen, maximal zu kompensierenden vertikalen Versatzes ist. Wie bereits zu den Figuren 6 und 7 beschrieben, wird mittels einer Detektionseinheit die Lage der Kontaktierungselemente 14 überprüft. Wie in Figur 8 ersichtlich, liegt in diesem Ausführungsbeispiel eine rechts angeordnete fehlerhafte Solarzelle F vor, bei welcher die horizontalen Reihen der Kontaktierungselemente 14 nach unten verschoben sind, gegenüber der Norm gemäß der linken und der mittleren Solarzelle. Es besteht somit ein vertikaler Versatz V, welcher durch die Positions-Detektionseinheit ermittelt wird. Die Steuereinheit modifiziert die Umformung der Verbindungsleiter zum Verbinden der mittleren und der rechten Solarzelle derart, dass im Bereich VA, welcher den Bereich zwischen den randständigen Kontaktierungselementen der mittleren Solarzelle und den randständigen Kontaktierungselementen der rechten Solarzelle entspricht, eine Kompensation des Versatzes V erfolgt, wie in Figur 8 ersichtlich.

Die vorangegangenen Beschreibungen insbesondere der Figuren 6, 7 und 8 zeigen vorteilhafte Anwendungen für Kennpunkte zur Detektion
- des Abstandes zwischen zwei benachbarten Halbleiterbauelementen,
- des Abstandes eines Kontaktierungspunktes eines Halbleiterbauelementes zu einem Rand, insbesondere dem nächstliegenden Rand des Halbleiterbauelementes,
- des Abstandes zwischen zwei Kontaktierungspunkten eines Halbleiterbauelementes und/oder
- des vertikalen Versatzes der Kontaktierungspunkte, insbesondere eines des vertikalen Versatzes von der Kontaktierungspunkten zweier benachbarter Halbleiterbauelemente.

Der detektierte Abstand oder Versatz wird bevorzugt mit einer vorgegebenen Norm verglichen und bei Abweichung erfolgt eine Anpassung einer oder mehrerer Periodenlängen der erzeugten periodischen Struktur des Verbindungsleiters, um die Abweichung zu kompensieren. Da auch mehrere der vorgenannten Abweichungen auftreten können ist es insbesondere vorteilhaft, mehrere, bevorzugt alle vorgenannten Abstände zu detektieren und gegebenenfalls eine Abweichung über eine Änderung einer oder mehrerer der Periodenlängen zu kompensieren.

## Patentansprüche

1. Bearbeitungsvorrichtung zum Umformen von Verbindungsleitern für Halbleiterbauelemente, insbesondere zum Ausbilden einer periodischen Struktur,
mit einer Formeinheit (1) zum Umformen zumindest eines Verbindungsleiters,
**dadurch gekennzeichnet,**
**dass** die Bearbeitungsvorrichtung eine Vorschubeinheit (3) aufweist, welche ausgebildet ist, Verbindungsleiter (2) und Formeinheit (1) in einer Vorschubrichtung relativ zueinander zu bewegen und
**dass** die Formeinheit (1) zumindest ein Anschlagelement (4), zumindest ein relativ zu dem Anschlagelement (4) verschiebbares Formelement (5) und eine Formelement-Verschiebeeinheit zum Verschieben des Formelementes (5) relativ zu dem Anschlagelement (4) aufweist, wobei das Formelement (5) in Vorschubrichtung hinter dem Anschlagelement (4), bevorzugt mittig zu dem Anschlagelement (4), angeordnet ist,
wobei Formelement (5), Anschlagelement (4) und Formelement-Verschiebeeinheit derart zusammenwirkend ausgebildet sind, dass der Verbindungsleiter (2) durch Verschieben des Formelements mittels der Formelement-Verschiebeeinheit zwischen Anschlagelement (4) und Formelement (5) biegbar ist.

2. Bearbeitungsvorrichtung nach Anspruch 1,
**dadurch gekennzeichnet**,
die Formeinheit (1) zusätzlich zu dem Anschlagelement (4) als erstes Anschlagelement (4) zumindest ein zweites Anschlagelement (4) und zusätzlich zu dem Formelement (5) als erstes Formelement (5) zumindest ein zweites Formelement (5) aufweist, welche derart angeordnet sind, dass der Verbindungsleiter (2) zwischen erstem und zweitem Anschlagelement (4) und zwischen dem ersten und zweitem Formelement (5) anordenbar ist.

3. Bearbeitungsvorrichtung nach Anspruch 2,
**dadurch gekennzeichnet,**
**dass** mittels der Formelement-Verschiebeeinheit das erste und das zweite Formelement (5) relativ zu erstem und zweitem Anschlagelement (4) verschiebbar sind, derart, dass mittels Verschieben des ersten Formelementes der Verbindungsleiter (2) in einer ersten Biegerichtung biegbar und mittels Verschieben des zweiten Formelementes der Verbindungsleiter (2) in einer zweiten Biegerichtung biegbar ist, wobei erste und zweite Biegerichtung unterschiedlich sind, bevorzugt entgegengesetzt.

4. Bearbeitungsvorrichtung nach einem der Ansprüche 2 bis 3,
**dadurch gekennzeichnet,**
**dass** erstes und zweites Formelement (5) auf einem gemeinsamen Formelementträger (6) angeordnet sind.

5. Bearbeitungsvorrichtung nach einem der vorangegangenen Ansprüche,
**dadurch gekennzeichnet,**
**dass** die Vorschubeinheit (3) der Formeinheit (1) in Vorschubrichtung des Verbindungsleiters vorgelagert oder nachgelagert ist, bevorzugt vorgelagert ist.

6. Bearbeitungsvorrichtung nach einem der vorangegangenen Ansprüche,
**dadurch gekennzeichnet,**
**dass** das Formelement (5) mittels der Formelement-Verschiebeeinheit in einer Verschieberichtung verschiebbar ist, welche mit der Vorschubrichtung einen Winkel im Bereich 45° bis 90° , bevorzugt 70° bis 90°, insbesondere 80° bis 90°, bevorzugt 90° einschließt.

7. Bearbeitungsvorrichtung nach einem der vorangegangenen Ansprüche,
**dadurch gekennzeichnet,**
**dass** die Bearbeitungsvorrichtung zur Bearbeitung einer Mehrzahl parallel geführter Verbindungsleiter (2) ausgebildet ist, insbesondere,
**dass** die Bearbeitungsvorrichtung eine Mehrzahl von Anschlagelementen (4) aufweist, welche bevorzugt in einer Reihe angeordnet sind, wobei zwischen zwei benachbarten Anschlagelementen (4) jeweils ein Verbindungsleiter (2) anordenbar ist und
**dass** die Bearbeitungsvorrichtung eine Mehrzahl von Formelement (5) aufweist, deren Anzahl bevorzugt der Anzahl der Anschlagelement (4) entspricht und welche bevorzugt in einer Reihe, insbesondere parallel zu den Anschlagelementen (4) angeordnet sind, wobei zwischen zwei benachbarten Formelementen (5) jeweils ein Verbindungsleiter (2) anordenbar ist, insbesondere,
**dass** die Mehrzahl von Formelementen (5) auf einem gemeinsamen Formelementträger (6) angeordnet ist, welcher mittels der Formelement-Verschiebeeinheit relativ zu den Anschlagelementen (4) verschiebbar ist.

8. Bearbeitungsvorrichtung nach einem der vorangegangenen Ansprüche,
**dadurch gekennzeichnet,**
**dass** die Bearbeitungsvorrichtung eine Steuereinheit aufweist, welche mit der Formelement-Verschiebeeinheit und der Vorschubeinheit verbunden und derart ausgebildet ist, dass mittels der Steuereinheit eine Amplitude und eine Periodenlänge für eine mittels der Bearbeitungsvorrichtung erzeugte periodische Struktur des Verbindungsleiters wahlweise vorgebbar sind.

9. Bearbeitungsvorrichtung nach Anspruch 8,
**dadurch gekennzeichnet,**
**dass** die Bearbeitungsvorrichtung eine Positions-Detektionseinheit zur Detektion von Kontaktierungspunkten eines Halbleiterbauelementes aufweist und die Positions-Detektionseinheit zusammenwirkend mit der Steuereinheit ausgebildet ist, so dass die mittels der Bearbeitungsvorrichtung erzeugte Form des Verbindungsleiters abhängig von Detektionsdaten der Positions-Detektionseinheit vorgebbar ist, insbesondere dass Amplitude und/oder Periodenlänge und/oder ein Versatz der periodischen Struktur abhängig von den Messdaten der Positions-Detektionseinheit vorgebbar sind.

10. Halbleiterkontaktierungseinheit (10) zur Kontaktierung eines Halbleiterbauelementes mit
einer Bearbeitungsvorrichtung nach einem der vorangegangenen Ansprüche und mit einer Kontaktierungseinheit (10) zum mechanischen und elektrischen Verbinden eines oder mehrerer Verbindungsleiter (2) mit dem Halbleiterbauelement (13), wobei die Kontaktierungseinheit (10) der Bearbeitungsvorrichtung nachgelagert angeordnet ist, so dass ein oder mehrere mittels der Bearbeitungsvorrichtung bearbeitete Verbindungsleiter (2) mit dem Halbleiterbauelement (13) mechanisch und elektrisch leitend verbindbar sind.

11. Verfahren zum Umformen von Verbindungsleitern für Halbleiterbauelemente, insbesondere zum Ausbilden einer periodischen Struktur,
folgende Verfahrensschritte umfassend:
A) Anordnen eines Verbindungsleiters zwischen einem Anschlagelement (4) und einem Formelement (5) einer Formeinheit (1);
B) Biegen des Verbindungsleiters durch Verschieben des Formelementes relativ zu dem Anschlagelement (4) und
C) Bewegen des Verbindungsleiters relativ zu der Formeinheit (1) in eine Vorschubrichtung, wobei vor einem Vorschub des Verbindungsleiters das Formelement (5) in eine Vorschubposition verfahren wird, so dass sich das Formelement (5) in Vorschubrichtung hinter dem Anschlagelement (4), bevorzugt mittig zu dem Anschlagelement (4) befindet.

12. Verfahren nach Anspruch 11,
**dadurch gekennzeichnet,**
**dass** während des Biegens des Verbindungsleiters nur ein geringfügiges Bewegen, bevorzugt kein Bewegen des Verbindungsleiters relativ zur Formeinheit (1) erfolgt.

13. Verfahren nach einem der Ansprüche 11 bis 12,
**dadurch gekennzeichnet,**
**dass** in Verfahrensschritt B) ein Biegen des Verbindungsleiters durch Verschieben des Formelementes relativ zu dem Anschlagelement (4) in einer ersten Verschieberichtung erfolgt und in einem Verfahrensschritt D) ein Biegen des Verbindungsleiters durch Verschieben eines weiteren Formelementes in eine zweite Verschieberichtung relativ zu einem zweiten Anschlagelement (4) erfolgt, wobei erste und zweite Verschieberichtung unterschiedlich, bevorzugt entgegengesetzt sind.

14. Verfahren nach Anspruch 13,
**dadurch gekennzeichnet,**
**dass** ein Abfolge B-C-D-C der Verfahrensschritte mehrfach wiederholt wird, insbesondere, dass in den Verfahrensschritten B und D kein Bewegen des Verbindungsleiters relativ zur Formeinheit (1) erfolgt.

15. Verfahren nach einem der Ansprüche 11 bis 14,
**dadurch gekennzeichnet,**
**dass** die Lage von Kennpunkten auf dem Halbleiterbauelement detektiert wird und abhängig von den Messdaten eine Kenngröße für die Bearbeitung des Verbindungsleiters vorgegeben wird, insbesondere, dass die mittels Umformung erzeugte Form des Verbindungsleiters abhängig von Detektionsdaten der Positions-Detektionseinheit vorgegeben wird, bevorzugt, dass eine Amplitude und/oder eine Periodenlänge und/oder ein Versatz für die Ausbildung einer periodischen Struktur vorgegeben wird.

## Claims

1. Processing device for shaping connection conductors for semiconductor components, especially for forming a periodic structure, having a shaping unit (1) for shaping at least one connection conductor,
**characterised in that**
the processing device has an advancing unit (3) which is configured to move connection conductor (2) and shaping unit (1) relative to one another in an advancement direction; and
the shaping unit (1) has at least one stop element (4), at least one shaping element (5) which is displaceable relative to the stop element (4), and a shaping element displacement unit for displacing the shaping element (5) relative to the stop element (4), the shaping element (5) being arranged behind the stop element (4) in the advancement direction, preferably centrally with respect to the stop element (4),
wherein shaping element (5), stop element (4) and shaping element displacement unit are configured to co-operate in such a way that the connection conductor (2) can be bent between stop element (4) and shaping element (5) by displacement of the shaping element by means of the shaping element displacement unit.

2. Processing device according to claim 1,
**characterised in that**
the shaping unit (1) has, in addition to the stop element (4) as first stop element (4), at least one second stop element (4) and, in addition to the shaping element (5) as first shaping element (5), at least one second shaping element (5), which are arranged in such a way that the connection conductor (2) is arrangeable between the first and second stop elements (4) and between the first and second shaping elements (5).

3. Processing device according to claim 2,
**characterised in that**
by means of the shaping element displacement unit the first and second shaping elements (5) are displaceable relative to the first and second stop elements (4) in such a way that, by displacement of the first shaping element, the connection conductor (2) can be bent in a first bending direction and, by displacement of the second shaping element, the connection conductor (2) can be bent in a second bending direction, the first and second bending directions being different, preferably being opposite.

4. Processing device according to either one of claims 2 and 3,
**characterised in that**
the first and second shaping elements (5) are arranged on a common shaping element support (6).

5. Processing device according to any one of the preceding claims,
**characterised in that**
the advancing unit (3) is arranged upstream or downstream, preferably upstream, of the shaping unit (1) in the advancement direction of the connection conductor.

6. Processing device according to any one of the preceding claims,
**characterised in that**
the shaping element (5) is displaceable by means of the shaping element advancing unit in a displacement direction that encloses with the advancement direction an angle in the range of from 45° to 90°, preferably from 70° to 90°, especially from 80° to 90°, preferably 90°.

7. Processing device according to any one of the preceding claims,
**characterised in that**
the processing device is configured for processing a plurality of connection conductors (2) guided in parallel; especially the processing device has a plurality of stop elements (4) which are preferably arranged in a row, a connection conductor (2) being arrangeable between each two adjacent stop elements (4); and the processing device has a plurality of shaping elements (5) the number of which preferably corresponds to the number of stop elements (4) and which are preferably arranged in a row, especially parallel to the stop elements (4), a connection conductor (2) being arrangeable between each two adjacent shaping elements (5); especially,
the plurality of shaping elements (5) is arranged on a common shaping element support (6) which is displaceable relative to the stop elements (4) by means of the shaping element displacement unit.

8. Processing device according to any one of the preceding claims,
**characterised in that**
the processing device has a control unit which is connected to the shaping element displacement unit and to the advancing unit and is configured in such a way that, by means of the control unit, an amplitude and a period length for a periodic structure of the connection conductor created by means of the processing device are specifiable as desired.

9. Processing device according to claim 8,
**characterised in that**
the processing device has a position detection unit for detecting contacting points of a semiconductor component and the position detection unit is configured so as to co-operate with the control unit, so that the shape of the connection conductor created by means of the processing device is specifiable in dependence upon detection data of the position detection unit; especially, amplitude and/or period length and/or an offset of the periodic structure are specifiable in dependence upon the measurement data of the position detection unit.

10. Semiconductor contacting unit (10) for contacting a semiconductor component, having a processing device according to any one of the preceding claims and having a contacting unit (10) for mechanically and electrically connecting one or more connection conductors (2) to the semiconductor component (13), the contacting unit (10) being arranged downstream of the processing device, so that one or more of the connection conductors (2) processed by means of the processing device are mechanically and electrically conductively connectible to the semiconductor component (13).

11. Method for shaping connection conductors for semiconductor components, especially for forming a periodic structure, comprising the following method steps:
A) arrangement of a connection conductor between a stop element (4) and a shaping element (5) of a shaping unit (1);
B) bending of the connection conductor by displacement of the shaping element relative to the stop element (4) and
C) movement of the connection conductor relative to the shaping unit (1) in an advancement direction, wherein prior to advancement of the connection conductor the shaping element (5) is moved into an advancement position, so that the shaping element (5) is located behind the stop element (4) in the advancement direction, preferably centrally with respect to the stop element (4).

12. Method according to claim 11,
**characterised in that**
during the bending of the connection conductor there is only very slight movement, preferably no movement, of the connection conductor relative to the shaping unit (1).

13. Method according to either one of claims 11 and 12,
**characterised in that**
in method step B), bending of the connection conductor is effected by displacement of the shaping element relative to the stop element (4) in a first displacement direction and, in a method step D), bending of the connection conductor is effected by displacement of a further shaping element in a second displacement direction relative to a second stop element (4), the first and second displacement directions being different, preferably being opposite.

14. Method according to claim 13,
**characterised in that**
a sequence B-C-D-C of the method steps is repeated multiple times; especially, in method steps B and D there is no movement of the connection conductor relative to the shaping unit (1).

15. Method according to any one of claims 11 to 14,
**characterised in that**
the position of characteristic points on the semiconductor component is detected and a parameter for processing the connection conductor is specified in dependence upon the measurement data; especially, the shape of the connection conductor created by means of the shaping is specified in dependence upon detection data of the position detection unit; preferably, an amplitude and/or a period length and/or an offset for the formation of a periodic structure is specified.

## Revendications

1. Dispositif d'usinage pour le formage de conducteurs de connexion pour des composants à semi-conducteur, en particulier pour la réalisation d'une structure périodique,
avec une unité de formage (1) pour le formage au moins d'un conducteur de connexion,
**caractérisé en ce que**
le dispositif d'usinage présente une unité d'avance (3) qui est réalisée afin de déplacer le conducteur de connexion (2) et l'unité de formage (1) dans un sens d'avance l'un par rapport à l'autre et
l'unité de formage (1) présente au moins un élément de butée (4), au moins un élément de formage (5) mobile par rapport à l'élément de butée (4) et une unité de déplacement d'élément de formage pour le déplacement de l'élément de formage (5) par rapport à l'élément de butée (4), dans lequel l'élément de formage (5) est agencé dans le sens d'avance derrière l'élément de butée (4), de préférence au milieu de l'élément de butée (4),
dans lequel l'élément de formage (5), l'élément de butée (4) et l'unité de déplacement de l'élément de formage sont réalisés par coaction de telle manière que le conducteur de connexion (2) soit flexible par déplacement de l'élément de formage au moyen de l'unité de déplacement d'élément de formage entre l'élément de butée (4) et l'élément de formage (5).

2. Dispositif d'usinage selon la revendication 1,
**caractérisé en ce que**
l'unité de formage (1) présente outre l'élément de butée (4) comme premier élément de butée (4) au moins un second élément de butée (4) et outre l'élément de formage (5) comme premier élément de formage (5) au moins un second élément de formage (5), qui sont agencés de telle manière que le conducteur de connexion (2) puisse être agencé entre le premier et le second élément de butée (4) et entre le premier et le second élément de formage (5).

3. Dispositif d'usinage selon la revendication 2,
**caractérisé en ce que**
au moyen de l'unité de déplacement d'élément de formage, le premier et le second élément de formage (5) sont mobiles par rapport au premier et au second élément de butée (4) de telle manière qu'au moyen du déplacement du premier élément de formage, le conducteur de connexion (2) soit flexible dans un premier sens de flexion et au moyen du déplacement du second élément de formage, le conducteur de connexion (2) soit flexible dans un second sens de flexion, dans lequel le premier et le second sens de flexion sont différents, de préférence opposés.

4. Dispositif d'usinage selon l'une des revendications 2 à 3,
**caractérisé en ce que**
le premier et le second élément de formage (5) sont agencés sur un support d'élément de formage (6) commun.

5. Dispositif d'usinage selon l'une des revendications précédentes,
**caractérisé en ce que**
l'unité d'avance (3) est logée en amont ou en aval de l'unité de formage (1) dans le sens d'avance du conducteur de connexion, de préférence est logé en amont.

6. Dispositif d'usinage selon l'une des revendications précédentes,
**caractérisé en ce que**
l'élément de formage (5) est mobile au moyen de l'unité de déplacement d'élément de formage dans un sens de déplacement qui forme avec le sens d'avance un angle dans la plage de 45° à 90°, de préférence de 70° à 90°, en particulier de 80° à 90°, de préférence de 90°.

7. Dispositif d'usinage selon l'une des revendications précédentes,
**caractérisé en ce que**
le dispositif d'usinage est réalisé pour l'usinage d'une pluralité de conducteurs de connexion (2) guidés parallèlement, en particulier
le dispositif d'usinage présente une pluralité d'éléments de butée (4) qui sont de préférence agencés dans une rangée, dans lequel respectivement un conducteur de connexion (2) peut être agencé entre deux éléments de butée (4) contigus et
le dispositif d'usinage présente une pluralité d'élément de formage, dont le nombre correspond de préférence au nombre d'élément de butée (4) et qui sont agencés de préférence dans une rangée, en particulier parallèlement aux éléments de butée (4), dans lequel respectivement un conducteur de connexion (2) peut être agencé entre deux éléments de formage (5) contigus,
en particulier que la pluralité d'éléments de formage (5) est agencée sur un support d'élément de formage (6) commun qui est mobile au moyen de l'unité de déplacement d'élément de formage par rapport aux éléments de butée (4).

8. Dispositif d'usinage selon l'une des revendications précédentes,
**caractérisé en ce que**
le dispositif d'usinage présente une unité de commande qui est reliée à l'unité de déplacement d'élément de formage et à l'unité d'avance et est réalisée de telle manière qu'au moyen de l'unité de commande, une amplitude et une longueur de période pour une structure périodique générée au moyen du dispositif d'usinage du conducteur de connexion puissent être prédéfinies au choix.

9. Dispositif d'usinage selon la revendication 8,
**caractérisé en ce que**
le dispositif d'usinage présente une unité de détection de position pour la détection de points de contact d'un composant à semi-conducteur et l'unité de détection de position est réalisée par coaction avec l'unité de commande de sorte que la forme générée au moyen du dispositif d'usinage du conducteur de connexion puisse être prédéfinie en fonction de données de détection de l'unité de détection de position, en particulier que l'amplitude et/ou la longueur de période et/ou un déport de la structure périodique puisse être prédéfini(e) en fonction de données de mesure de l'unité de détection de position.

10. Unité de contact de semi-conducteur (10) pour le contact d'un composant à semi-conducteur avec un dispositif d'usinage selon l'une des revendications précédentes et avec une unité de contact (10) pour la connexion mécanique et électrique d'un ou plusieurs conducteurs de connexion (2) avec le composant à semi-conducteur (13), dans lequel l'unité de contact (10) est agencée en aval du dispositif d'usinage de sorte qu'un ou plusieurs conducteurs de connexion (2) usinés au moyen du dispositif d'usinage puissent être reliés au composant à semi-conducteur (13) de manière mécanique et électroconductrice.

11. Procédé de formage de conducteurs de connexion pour des composants à semi-conducteur, en particulier pour la réalisation d'une structure périodique,
comprenant les étapes de procédé suivantes :
A) l'agencement d'un conducteur de connexion entre un élément de butée (4) et un élément de formage (5) d'une unité de formage (1) ;
B) la flexion du conducteur de connexion par déplacement de l'élément de formage par rapport à l'élément de butée (4) et
C) le déplacement du conducteur de connexion par rapport à l'unité de formage (1) dans un sens d'avance, dans lequel avant une avance du conducteur de connexion, l'élément de formage (5) est déplacé dans une position d'avance de sorte que l'élément de formage (5) se trouve dans le sens d'avance derrière l'élément de butée (4), de préférence au milieu de l'élément de butée (4).

12. Procédé selon la revendication 11,
**caractérisé en ce que**
pendant la flexion du conducteur de connexion, seul un léger déplacement, de préférence aucun déplacement du conducteur de connexion par rapport à l'unité de formage (1) n'est effectué.

13. Procédé selon l'une des revendications 11 à 12,
**caractérisé en ce que**
dans l'étape de procédé B), une flexion du conducteur de connexion est effectuée par déplacement de l'élément de formage par rapport à l'élément de butée (4) dans un premier sens de déplacement et dans une étape de procédé D), une flexion du conducteur de connexion est effectuée par déplacement d'un autre élément de formage dans un second sens de déplacement par rapport à un second élément de butée (4), dans lequel le premier et le second sens de déplacement sont différents, de préférence opposés.

14. Procédé selon la revendication 13,
**caractérisé en ce que**
une suite B-C-D-C des étapes de procédé est répétée de manière multiple, en particulier que dans les étapes de procédé B et D, aucun déplacement du conducteur de connexion n'est effectué par rapport à l'unité de formage (1).

15. Procédé selon l'une des revendications 11 à 14,
**caractérisé en ce que**
la position de points caractéristiques est détectée sur le composant à semi-conducteur et en fonction des données de mesure, une grandeur caractéristique pour l'usinage du conducteur de connexion est prédéfinie, en particulier que la forme générée par formage du conducteur de connexion est prédéfinie en fonction de données de détection de l'unité de détection de position, de préférence qu'une amplitude et/ou une longueur de période et/ou un déport pour la réalisation d'une structure périodique est prédéfini(e) .
